# FASCICULE DE BREVET EUROPEEN

(11) **EP 2 107 623 B1**
(45) Date de publication et mention de la délivrance du brevet: **17.02.2010**
(21) Numéro de dépôt: 09356014.2
(22) Date de dépôt: 19.02.2009
(51) Int. Cl.: H01L 43/08, H01L 27/22, H03B 15/00

(54) **Dispositif magnétique intégrant un empilement magnétorésistif et au moins un nanocontact**
Magnetvorrichtung, die einen magnetoresistiven Stapel und mindestens einen Nanokontakt umfasst
Magnetic device including a magnetoresistive stack and at least one nanocontact

(30) Priorité: 03.04.2008 FR 0852236
(43) Date de publication de la demande: 07.10.2009
(73) Titulaire: Commissariat à l'Energie Atomique, 75015 Paris (FR)
(72) Inventeur: Sousa, Véronique, 38000 GRENOBLE (FR); Nodin, Jean-François, 38120 SAINT EGREVE (FR); Cyrille, Marie-Claire, 38650 SINARD (FR); Delaet, Bertrand, 38190 BERNIN (FR)
(74) Mandataire: Vuillermoz, Bruno

(56) Documents cités:
- WO-A-2005/064783
- FR-A- 2 892 871
- US-A1- 2007 236 105

## Description

### DOMAINE DE L'INVENTION

La présente invention a trait au domaine des éléments magnétiques à jonction tunnel magnétiques ou à vanne de spin, tels que ceux mis en oeuvre dans les oscillateurs radio fréquences, mais également mis en oeuvre dans les mémoires magnétiques à accès aléatoire, permettant, de manière connue le stockage, la lecture et l'écriture de données dans les systèmes électroniques.

Les oscillateurs radio fréquence, pour lesquels l'invention trouve à s'appliquer, sont des dispositifs destinés à fonctionner dans des gammes de fréquence comprises entre le GHz et les dizaines de GHz, de tels oscillateurs radio fréquence étant plus particulièrement mis en oeuvre dans le domaine des télécommunications.

L'invention trouve à s'appliquer également aux mémoires magnétiques à accès aléatoire non volatiles, désignées de manière traditionnelle sous l'acronyme MRAM, constituées d'un ensemble de points mémoire formés chacun par une jonction tunnel magnétique, également désignée sous l'acronyme JTM.

### ETAT ANTERIEUR DE LA TECHNIQUE

Des différents dispositifs magnétiques connus à ce jour, et plus particulièrement destinés à constituer des mémoires MRAM ou des oscillateurs radio fréquence, on connaît ceux dits à transfert de spin. Leur fonctionnement est basé sur les effets de magnétorésistance géante, comme pour les vannes de spin, et sur les effets de magnétorésistance tunnel, comme pour les jonctions tunnel magnétiques JTM.

Ces structures consistent en un empilement de couches magnétiques, dont la nature et l'arrangement sont réalisés de telle manière que lorsqu'un courant électrique les traverse, il est possible d'obtenir une résistance variable en fonction du champ magnétique appliqué et/ou du courant polarisé en spin qui les traverse.

Un tel dispositif est constitué de l'empilement de deux couches ferromagnétiques séparées par une couche amagnétique (non magnétique) classiquement dénommée espaceur, réalisé en métal pour les vannes de spin ou en oxyde pour les jonctions tunnel magnétiques.

De manière connue, lorsque l'orientation de l'aimantation des deux couches ferromagnétiques est identique, on parle alors d'orientations parallèles, le dispositif est dans l'état de basse résistance. Corollairement, lorsque l'orientation des deux couches ferromagnétiques est antiparallèle, le dispositif se trouve dans l'état dit de haute résistance.

L'électronique de spin utilise le spin des électrons comme degré de liberté supplémentaire, afin de générer des effets nouveaux. Le spin des électrons est à l'origine de phénomènes magnétorésistifs dans les multicouches magnétiques, tel que notamment la magnétorésistance géante ou la magnétorésistance tunnel.

On a en effet pu montrer qu'en faisant passer un courant polarisé en spin à travers une couche mince magnétique, on pouvait induire un renversement de son aimantation en l'absence de tout champ magnétique externe. Le courant polarisé en spin peut également générer des excitations magnétiques entretenues, également dénommées oscillations. L'utilisation de l'effet de génération d'excitations magnétiques entretenues dans un dispositif magnéto-résistif permet de convertir cet effet en une modulation de tension haute fréquence directement utilisable dans les circuits électroniques, et donc corollairement susceptible d'intervenir directement au niveau de la fréquence.

Les empilements magnétorésistifs mis en oeuvre tant pour la réalisation de tels oscillateurs que pour celle le de points mémoire pour mémoires magnétiques, utilisent deux techniques différentes (cf. US2007/236105 A1 ou FR 2 892 871 A):
- les empilements dits « en pilier » : l'ensemble des couches est gravé pour réaliser un pilier d'un diamètre de l'ordre de 50 à 300 nm;
- les empilements dits « point contact » : dans un tel empilement, les couches actives et notamment ferromagnétiques, ne sont pas gravées avec des motifs nanométriques ou, si elles le sont, sont alors fabriquées selon des motifs très grands (typiquement voisins du micromètre carré). On réalise un contact métallique très étroit, typiquement 20 à 50 nm, au dessus de l'empilement magnétique au moyen d'une nanopointe externe ou interne.

Les empilements du second type précité également appelé « nanocontacts » sont préférés, notamment lorsque l'on met en oeuvre des vannes de spin en vue de la réalisation d'oscillateurs radio fréquence, car ils produisent des émissions radio fréquences mieux définies et notamment des émissions radio fréquences plus fines. On a en effet pu observer une diminution de la largeur des raies d'émission radio fréquence, diminution que l'on attribue à la minimisation des effets de bord inhérents au procédé de fabrication.

Au surplus, l'utilisation des nanocontacts permet d'augmenter la densité d'intégration des dispositifs magnétiques, de confiner le courant dans les couches magnétiques permettant une homogénéisation des effets physiques, outre une réduction des champs bipolaires perturbateurs. En particulier dans le cadre de la réalisation d'oscillateurs radio fréquence, la mise en oeuvre de nanocontacts permet d'obtenir des facteurs de qualité Q=f/Δf très élevés.

Or, de tels oscillateurs radio fréquence sont, comme déjà dit, plus particulièrement mis en oeuvre dans le cadre de dispositifs de télécommunication, tels que notamment les téléphones cellulaires pour lesquels on recherche de plus en plus l'application du principe de l'allocation dynamique de fréquence pour résoudre le problème né de la saturation des bandes de fréquence attribuées au secteur des télécommunications. Or, pour mettre en oeuvre un tel principe d'allocation dynamique de fréquence, il convient de disposer d'oscillateurs à très larges bandes et très performants en bruits de phase, nécessitant dès lors un facteur de qualité Q très élevé.

Sur le plan technologique, la réalisation de tels nanocontacts n'est pas industrialisable avec les techniques actuelles. En effet, celles-ci requièrent des outils très lourds à mettre en oeuvre, tels que faisceau d'ions focalisé (FIB : *« Focused Ion Beam* ») et électrodéposition, pointes AFM (*« Atomic Force Microscope »: microscope à force atomique*) pour la réalisation de nano-indentations, c'est-à-dire une méthode pour réaliser un par un des orifices dans une résine planarisante, les séquences photolithographiques EBEAM (écriture par faisceau d'électrons)/gravure métal/planarisation ou encore EBEAM/gravure oxyde/remplissage, notamment lorsque l'on souhaite obtenir des dimensions de contact bien inférieures à 50 nm.

L'objectif visé par la présente invention réside dans la réalisation de tels nanocontacts au niveau d'empilements magnétiques, et ce, au moyen d'une autre technologie, plus facilement industrialisable et permettant une optimisation de l'intégration des composants.

### EXPOSE DE L'INVENTION

L'invention se propose de solutionner le problème posé en faisant appel à la mise en oeuvre d'une bicouche, constitué d'une électrode soluble, dissoute à tout le moins partiellement, dans un électrolyte solide, et qui, en suite de cette dissolution, et en fonction de paramètres électriques appliqués à l'empilement muni ou revêtu d'un tel bicouche, va permettre de générer un chemin conducteur de dimensions particulièrement réduites, et en tout cas, compatible avec les objectifs recherchés.

Plus particulièrement, l'invention vise un dispositif magnétique intégrant :
■ un empilement magnétorésistif, ledit empilement comprenant au moins deux couches réalisées en un matériau ferromagnétique, séparées l'une de l'autre par une couche en un matériau amagnétique;
■ et des moyens pour faire circuler un courant d'électrons perpendiculairement au plan desdites couches, intégrant au moins un nanocontact destiné à injecter ledit courant au sein de l'empilement magnétorésistif.

Selon l'invention, le nanocontact est réalisé au sein d'une bicouche composée d'un électrolyte solide sur lequel a été déposée une électrode soluble composée d'un métal, et dissoute à tout le moins partiellement dans l'électrolyte.

De par la mise en oeuvre d'une telle bicouche, électrolyte solide/électrode soluble entre l'empilement magnétique et l'une des électrodes de contact acheminant un courant électrique, il se crée sous certaines conditions de polarisation, un chemin conducteur de taille particulièrement limitée, typiquement limité à quelques atomes et au plus voisin de quelques nanomètres.

On s'affranchit donc des difficultés inhérentes aux technologies traditionnelles pour la réalisation de tels nanocontacts tout en bénéficiant des avantages physiques nés de la mise en oeuvre de ces nanocontacts et rappelés en préambule, et ce tant pour la réalisation de mémoires magnétiques que pour celle d'oscillateurs radio fréquence.

Selon l'invention, le courant électrique traversant l'empilement magnétique peut être polarisé en spin.

Selon l'invention, l'électrolyte est constitué d'un chalcogenure et plus particulièrement choisi dans le groupe comprenant GeSe ou GeS ou GeTe ou As₂Se.

L'électrode soluble est quant à elle choisie dans le groupe comprenant l'argent, le cuivre, le cobalt, le zinc, l'indium et le platine.

De manière connue, lorsque la bicouche ainsi réalisée est soumise à une phase de traitement UV ou de traitement thermique (dans un four entre 100 et 400 °C, fonction du matériau mis en oeuvre et du temps de recuit), on aboutit à une dissolution, à savoir qu'une partie de l'électrode soluble se dissout dans l'électrolyte solide pour constituer une matrice isolante du type MGeS ou MGeSe ou MGeTe ou MAs₂Se, dans laquelle M désigne le métal dissout issu de l'électrode soluble.

De manière connue, en fonction de la tension appliquée aux bornes d'une telle matrice, deux modes de fonctionnement sont susceptibles d'être mis en oeuvre.

Tout d'abord, si l'on applique une tension suffisante, c'est-à-dire supérieure à une tension de seuil dénommée Vₜₕ, correspondant à la tension minimale à appliquer en dessous de laquelle rien ne se passe, et typiquement comprise entre 0.2V et 1V, il se crée un chemin conducteur au travers de la matrice, dont la taille au plus nanométrique et la résistance électrique dépendent du courant électrique qui traverse la matrice, appelé courant de compliance I_{comp}.

Ainsi, aussi longtemps que le courant traversant la matrice ne dépasse pas un courant dit de saturation Iₛₐₜ, c'est à dire le courant a partir duquel le chemin conducteur est crée de manière définitive, la résistance ne variant plus du tout : typiquement entre quelque mA et 100mA, le nanocontact également dénommé nano chemin conducteur, peut être effacé et réécrit.

En revanche, si le courant de saturation Iₛₐₜ est dépassé, le nanocontact ou nano chemin conducteur est irréversiblement créé, et devient donc permanent. Dans cette configuration, tant sa taille que sa résistance électrique sont fixées par le courant de saturation Iₛₐₜ.

Selon un mode particulier de réalisation de l'invention, on monte entre l'empilement de couches magnétiques et l'une des électrodes de contact un réseau de nanocontacts, constitués chacun d'une bicouche du type de celle précédemment décrite, lesdits réseaux étant montés en parallèle ou en série. Cette forme de réalisation est plus particulièrement destinée à la réalisation d'oscillateurs radio fréquence à transfert de spin.

Selon une autre variante de l'invention, on met à contribution la bicouche du type précédemment décrit pour faire fonction de polariseur dans le cadre de la réalisation d'un oscillateur radio fréquence. En d'autres termes, par sélection particulière de ladite bicouche, et plus particulièrement du métal constituant l'électrode soluble, et notamment s'il s'agit du cobalt, on confère à la matrice en résultant une très forte anisotropie de forme permettant ainsi de transférer la fonction de polariseur de l'empilement magnétique à ladite matrice.

Selon encore un autre mode de réalisation de l'invention, on met en oeuvre de part et d'autre de l'empilement magnétique la bicouche de l'invention. Ce faisant, on crée ainsi des nanocontacts de dimensions réduites, permettant d'aboutir à une optimisation du confinement des lignes de courant et donc d'améliorer les performances du dispositif.

### BREVE DESCRIPTION DES DESSINS

La manière dont l'invention peut être réalisée et les avantages qui en découlent ressortiront mieux des exemples de réalisation qui suivent, donnés à titre indicatif et non limitatif, à l'appui des figures annexées.
La figure 1 est une représentation schématique du principe général soustendant la présente invention.
Les figures 2 et 3 sont des variantes de réalisation de l'invention.
Les figures 4, 5 et 6 sont des représentations schématiques visant à illustrer un réseau de nanocontacts.
La figure 7 est une représentation schématique d'une autre variante de réalisation de l'invention, illustrant la mise en oeuvre d'un double nanocontact.

### MODE DE REALISATION DE L'INVENTION

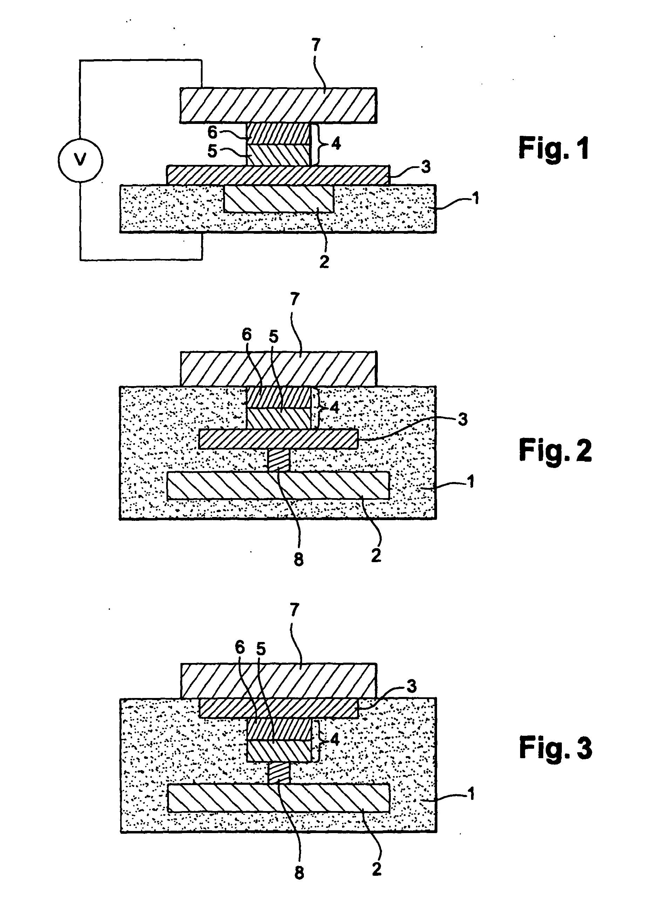

On a décrit en relation avec la figure 1 un mode typique de réalisation de l'invention, aussi bien destiné à un empilement magnétique de type vanne de spin que de jonction tunnel magnétique.

Dans celui-ci, est intégrée dans un substrat **1,** typiquement réalisé en silicium, l'électrode inférieure **2** conductrice électrique, destinée à acheminer le courant électrique de lecture ou d'écriture, dans le cas d'une mémoire magnétique, ou de réalisation de la précession de l'aimantation de l'une des couches d'un empilement magnétique **3,** ci-après décrit plus en détail, dans le cas d'un oscillateur radio fréquence.

L'empilement **3** est réalisé sur le substrat, et est d'un type en soi connu.

S'agissant d'une jonction tunnel magnétique, il comporte deux couches de matériaux ferromagnétiques tels que notamment en alliage CoFe ou NiFe. Ces deux couches sont séparées l'une de l'autre soit par un matériau isolant, et notamment un oxyde tel que par exemple de l'alumine, pour constituer une jonction tunnel magnétique, soit par un métal, et par exemple le cuivre, pour réaliser une vanne de spin.

Typiquement, cet empilement magnétique présente une largeur, ou un diamètre de plusieurs microns et une épaisseur voisine de 50 nanomètres.

Selon une caractéristique de l'invention, cet empilement magnétique **3** n'est pas directement en contact avec l'électrode supérieure **7,** destinée en coopération avec l'électrode inférieure **2** à permettre le passage d'un courant électrique perpendiculairement au plan des couches de l'empilement magnétique **3,** mais, vient au contact d'une bicouche **4,** respectivement constitué avant tout traitement d'un électrolyte solide **5** et d'une électrode soluble **6.**

Dans l'exemple décrit, l'électrolyte solide **5** est par exemple constitué d'un chalcogenure GeSe ou GeS ou GeTe ou As₂Se d'une épaisseur variant de 5 à 50 nanomètres. Il est déposé sur l'empilement magnétique **3.** Ce dépôt peut être réalisé par les techniques classiques, telles que PVD (« *Phase Vapour Deposition* »), CVD (« *Chemical Vapour Deposition* »), ou par évaporation, et ceci tant pour l'électrolyte solide que pour l'électrode soluble. Ce dépôt vient donc au contact de l'une des couches ferromagnétiques dudit empilement magnétique.

Corollairement, l'électrode soluble **6** est constituée d'argent ou de cuivre ou de zinc ou d'indium et de platine, et présente également une épaisseur de 5 à 50 nanomètres avant traitement de dissolution.

La largeur ou diamètre de cette bicouche **4** est supérieur à **45** nanomètres, et peut typiquement atteindre 300 nanomètres (selon la précision disponible pour la lithographie).

Afin d'aboutir à la création d'un nano chemin conducteur, c'est-à-dire d'un nanocontact, réversible ou irréversible, on soumet tout d'abord la bicouche ainsi constituée à un traitement ultraviolet ou à un traitement thermique, aboutissant à la dissolution, à tout le moins partielle de la couche **6** constitutive de l'électrode soluble au sein de l'électrolyte solide 5. Ce faisant, on aboutit par exemple à la constitution d'une matrice CuGeSe ou CuGeS ou AgGeSe ou AgGeS. L'épaisseur de l'électrode n'est pas modifiée de manière notable.

La conductivité de l'électrolyte solide avant traitement de dissolution de l'électrode soluble est voisine de 10⁻¹¹ Ω⁻¹ m⁻¹

Corollairement, après traitement de dissolution de l'électrode soluble au sein de l'électrolyte solide, on aboutit à une conductivité de l'ordre de 10⁻² Ω⁻¹ m⁻¹.

En revanche, si l'on soumet l'ensemble de l'empilement décrit en relation avec la figure **1** à une tension supérieure à la tension seuil Vₜₕ, typiquement comprise entre 0,2 Volt et **1** Volt, la résistivité devient supérieur à 10⁵ Ω⁻¹ m⁻¹ conduisant à une résistance du ou des nanocontacts qui se constituent au sein de la matrice voisine de quelques ohms à quelques dizaines d'ohms.

L'électrode supérieure **7** est en général déposée après dissolution. Cependant, les techniques actuelles permettent d'envisager le dépôt de cette électrode avant dissolution de l'électrode soluble.

Comme déjà indiqué en préambule, il est possible de soumettre le dispositif ainsi réalisé à deux régimes différents, fonction de l'application envisagée.

Ainsi, en maintenant le dispositif à une tension supérieure à la tension seuil V_{th,} mais en prenant soin de faire traverser l'ensemble par un courant électrique de compliance inférieur au courant de saturation, typiquement voisin de 10 à 100 milli ampères dans l'exemple décrit, le nano - chemin ou les nano - chemins réalisés au sein de la matrice **4** ne sont pas irréversibles et peuvent notamment être effacés puis réécrits lors du nouvel état ultérieur de mise sous tension. La taille et la résistance du nano chemin conducteur ainsi réalisé au sein de la matrice **4** dépendent directement du courant de compliance lors de l'initialisation. Pour effacer ce nanocontact ou nano chemin conducteur, il suffit de changer le sens de polarisation et de dépasser la tension d'effacement, typiquement comprise entre -50mV et -500mV, cette tension étant déterminée expérimentalement en balayage négatif. Pour réinitialiser, il convient en revanche d'appliquer toujours une tension supérieure à la tension seuil Vₜₕ.

Selon ce mode de fonctionnement, c'est-à-dire à chemin de courant ajustable et/ou reprogrammable, on est en mesure de conférer un degré de liberté supplémentaire pour le pilotage de ce dispositif. Ainsi, dans le cadre de la réalisation d'un oscillateur radio fréquence à transfert de spin, le contrôle de la taille et de la résistance du filament conducteur ou nano-chemin conducteur par le choix particulier du courant de compliance, permet l'ajustement de la densité de courant et par voie de conséquence, la plage de fonctionnement en fréquence. On augmente la fonctionnalité de l'oscillateur en donnant accès à différents modes de fonctionnement en fréquence selon la taille du nanocontact donc de la densité de courant.

L'autre mode de fonctionnement d'un tel dispositif revient à constituer un nano - chemin conducteur permanent ou irréversible. Pour ce faire, lors de l'initialisation, il convient toujours d'appliquer une tension V> Vₜₕ et en outre, de faire circuler un courant I > Iₛₐₜ. Le nano - chemin conducteur ou nanocontact est, dans cette **configuration,** irréversiblement créé et devient donc permanent. Sa taille et sa résistance sont alors ici fixées par le courant de saturation. Ce mode de fonctionnement est plus particulièrement mis en oeuvre pour réaliser des nanocontacts pour oscillateurs RF à grande cohérence et faible largeur de raie, mais également pour réaliser des MRAM.

L'avantage de ce mode est de pouvoir disposer d'une injection en courant tout particulièrement localisée, et notamment limitée à quelques atomes ou à quelques nanomètres en fonction du courant de compliance injecté (Iₛₐₜ) sans pour autant perdre en conductivité électrique.

Au surplus, ce mode de fonctionnement permet d'aboutir à une très bonne intégration, et donc à un confinement. Cette technologie s'avère par ailleurs relativement facilement industrialisable en raison de la simplicité de fabrication : simples techniques de dépôt, et étape de dissolution. En outre, elle permet d'aboutir à une densité d'intégration élevée, outre à un auto-alignement du nanocontact sur l'empilement magnétique en raison de la technique de dépôt de la bicouche 4 sur ledit empilement 3. Enfin, elle permet une optimisation de la performance des oscillateurs, en raison de l'injection extrêmement localisée du courant.

On a illustré au sein des figures 2 et 3, une variante de la structure précédemment décrite. Ainsi, on peut intercaler entre l'électrode inférieure et l'empilement magnétique un via (ou plug) **8,** par exemple réalisé en tungstène ou en cuivre, propre à favoriser le confinement du courant électrique au travers de l'empilement. Ce via peut être positionné entre l'électrode inférieure **2** et l'empilement magnétique **3** (figure 2), ou entre l'électrode inférieure **2** et la bicouche **4** (figure 3). Le mode de réalisation de la figure 2 permet plus particulièrement d'assurer le confinement du courant dans les couches magnétiques. Elle présente l'avantage de pouvoir réaliser les différents dépôts in situ.

Le mode de réalisation da figure 3 a pour objectif d'illustrer une autre variante technologique, mettant en oeuvre une étape de planarisation des dépôts chalcogénure avant le dépôt des couches magnétiques.

Selon une autre variante de l'invention, plus particulièrement destinée à la réalisation d'un oscillateur radio fréquence, on transfère à tout le moins en partie la fonction de polarisation en spin du courant électrique de l'une des couches ferromagnétiques constitutives de l'empilement magnétique **3** à la matrice **4** résultant de la bicouche.

A cet effet, on remplace le cuivre ou l'argent constitutifs de l'électrode soluble **6** par du cobalt, tout en conservant des dimensions sensiblement analogues à celles précédemment décrites des deux couches respectives, de l'électrolyte solide et de l'électrode soluble. Ce faisant, la matrice au sein de laquelle est réalisé un nanocontact, tel que précemment indiqué, sert également de polariseur perpendiculaire à très forte anisotropie de forme, et propre ainsi à optimiser la modulation de résistance électrique résultant du courant polarisé en spin traversant l'empilement magnétique **3.** Cette configuration permet de polariser les spin perpendiculairement aux aimantations des couches ferromagnétiques libre et piégée de la vanne de spin ou de la jonction tunnel magnétique. L'avantage de la mise en oeuvre d'un polariseur perpendiculaire réside tout d'abord, dans la diminution du courant critique (nécessaire à la précession ou au retournement de l'aimantation de la couche ferromagnétique), ensuite, dans l'obtention de davantage de signal de sortie de la tension RF dans les oscillateurs à transfert de spin, et enfin, dans la possibilité d'obtenir des oscillations en champ magnétique nul.

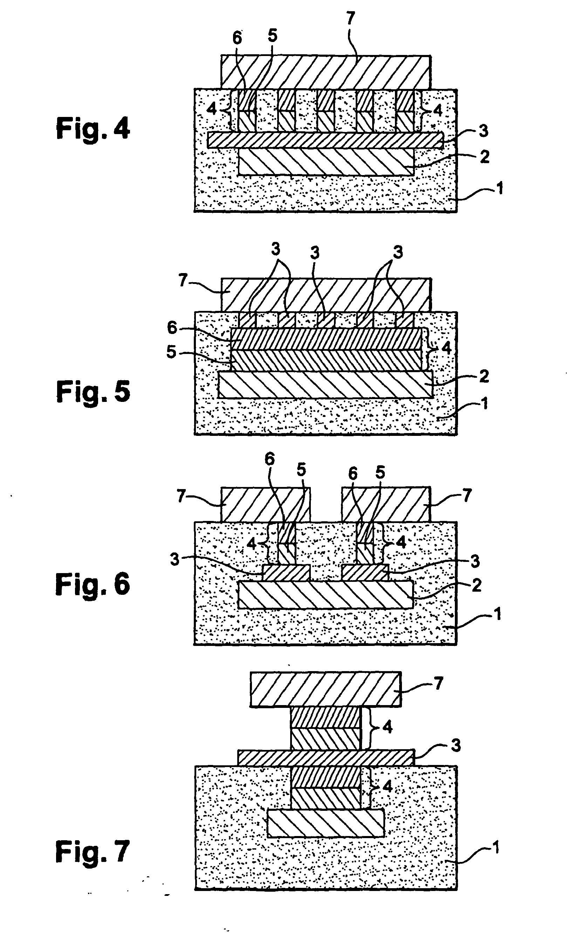

On a représenté, en relation avec les figures 4 et 5, une autre application envisageable de l'invention, mettant en oeuvre un réseau de nanocontacts en parallèle, en lieu et place d'un seul nanocontact comme décrit en relation avec les figures 1 à 3. Là encore, cette configuration est plus particulièrement destinée à la réalisation d'oscillateurs radio fréquence à transfert de spin.

Ce mode de réalisation repose sur le même principe de fabrication que celui décrit en relation avec la figure 1, sauf qu'au lieu de pattemer (en l'occurrence une lithographie, une gravure, un remplissage oxyde et une planarisation) un motif sous l'électrode supérieure, on en patterne plusieurs. (Il n'y a qu'une seule bicouche qui est gravée de manière à avoir plusieurs motifs)

En alternative, on dépose sur l'électrode inférieure une seule bicouche **4,** et un seul empilement magnétique **3,** cet empilement étant gravé de manière à obtenir une multitude de motifs, lesdits motifs étant séparés là encore les uns des autres par un isolant type silice, lesdits motifs étant alors au contact avec l'électrode supérieure par exemple réalisée en cuivre.

Cette structure permet d'augmenter l'efficacité de l'oscillateur radio fréquence mettant en oeuvre de telles configurations. En effet, on aboutit dans ce cas à la mise en oeuvre de N oscillateurs couplés les uns aux autres. La puissance de sortie s'en trouve fortement augmentée et en l'espèce, proportionnelle à N², et le facteur de qualité augmente également. Un tel réseau de nano oscillateurs est par exemple décrit dans la publication [Mutual phase-locking of microwave spin torque nano-oscillators, S. KAKA et al., Nature vol. 437, p. 389, 2005 ou Phase Locking in double point contact spin transfer devices, F.B. Mancoff et al., Nature Vol. 437, p. 393, 2005].

On a représenté en relation avec la figure 6 une autre configuration envisageable selon l' invention, dans laquelle les nanocontacts ne sont plus en parallèle mais en série. Dans cette hypothèse, et ainsi qu'on peut l'observer, l'électrode supérieure n'est plus continue mais est constituée de plusieurs électrodes isolées les unes des autres. Cette configuration constitue un autre exemple de réalisation pour connecter N oscillateurs.

Il est possible, en utilisant le mode de fonctionnement réversible et programmable décrit précédemment, c'est-à-dire avec I_{comp} < Iₛₐₜ, d'améliorer et surtout de contrôler le couplage par le contrôle de la densité du courant de chaque nanocontact injecté dans l'empilement ou dans les empilements électromagnétiques **3,** et ce particulièrement, si les électrodes permettant de piloter les nanocontacts sont indépendantes (c'est-à-dire si chaque nano oscillateur peut être polarisé indépendamment). On ajuste dans ce cas les polarisations au niveau de chaque nanocontact pour avoir un couplage optimum entre les nano oscillateurs.

Selon encore une autre configuration, représentée en relation avec la figure 7, on dispose de part et d'autre de l'empilement magnétique **3** une bicouche **4** du type de celle précédemment décrite, avec l'électrolyte solide **5** de chacune des deux bicouches en contact avec les deux faces opposées de l'empilement magnétique **3.** Les dimensions des couches respectives demeurent sensiblement équivalentes à celles précédemment indiquées.

Ce faisant, de par la mise en oeuvre de tels nanocontacts de part et d'autre de l'empilement, on optimise le confinement des lignes de courant traversant l'empilement magnétique, et par voie de conséquence, on améliore les performances du dispositif en résultant. Comme déjà dit, en confinant ainsi les lignes de courant, on permet d'aboutir à une homogénéisation des effets physiques de par l'absence à tout le moins la diminution drastique des effets de bord, et en outre, on augmente la densité d'intégration de ces dispositifs, souci permanent de l'homme du métier dans le domaine considéré.

## Revendications

1. Dispositif magnétique intégrant :
■ un empilement magnétorésistif (3), ledit empilement comprenant au moins deux couches réalisées en un matériau ferromagnétique, séparées l'une de l'autre par une couche en un matériau amagnétique ;
■ et des moyens (2, 4, 7) pour faire circuler un courant d'électrons perpendiculairement au plan desdites couches, intégrant au moins un nanocontact destiné à injecter ledit courant au sein de l'empilement magnétorésistif (3),
***caractérisé* en ce que** le nanocontact est réalisé au sein d'une bicouche (4) composée d'un électrolyte solide (5) sur lequel a été déposée une électrode soluble (6) composée d'un métal, et dissoute à tout le moins partiellement dans ledit électrolyte.

2. Dispositif magnétique selon la revendication 1, ***caractérisé* en ce que** le courant électrique traversant l'empilement magnétique est polarisé en spin.

3. Dispositif magnétique selon l'une des revendications 1 et 2, ***caractérisé* en ce que** la dissolution à tout le moins partielle de l'électrode soluble au sein de l'électrolyte solide est réalisée par traitement UV ou traitement thermique.

4. Dispositif magnétique selon l'une des revendications 1 à 3, ***caractérisé* en ce que** l'électrolyte solide (5) est constitué d'un chalcogenure, plus particulièrement choisi dans le groupe comprenant GeSe ou GeS ou GeTe ou As₂Se.

5. Dispositif magnétique selon l'une des revendications 1 à 4, ***caractérisé* en ce que** l'électrode soluble (6) est choisie dans le groupe comprenant l'argent, le cuivre, le cobalt, l'indium, le zinc et le platine.

6. Dispositif magnétique selon l'une des revendications 1 à 5, ***caractérisé* en ce que** la tension appliquée à ses bornes est supérieure à une tension de seuil (Vₜₕ), et **en ce que** le courant d'électrons traversant ledit empilement magnétique est inférieur au courant de saturation et est pilotable, en fonction de la dimension souhaitée du ou des nanocontacts réalisés au sein de la bicouche (4).

7. Dispositif magnétique selon l'une des revendications 1 à 5, ***caractérisé* en ce que** la tension appliquée à ses bornes est supérieure à une tension de seuil (Vₜₕ), et **en ce que** le courant d'électrons traversant ledit empilement magnétique est supérieur au courant de saturation, de telle sorte à réaliser des nanocontacts irréversibles au sein de la bicouche (4).

8. Dispositif magnétique selon l'une des revendications 1 à 7, ***caractérisé* en ce qu'**il comprend entre l'empilement de couches magnétiques (3) et l'une des électrodes de contact (2, 7) un réseau de nanocontacts, constitués chacun d'une bicouche (4), ledit réseau étant monté en parallèle ou en série.

9. Dispositif magnétique selon l'une des revendications 1 à 7, ***caractérisé* en ce qu'**une bicouche (4) est positionnée de part et d'autre de l'empilement magnétique (3), l'électrolyte solide (5) de chacune desdites bicouches étant en contact avec ledit empilement, au niveau des faces opposées de ce dernier.

10. Mémoire magnétique à accès aléatoire constituée d'une pluralité de points mémoire,
***caractérisée* en ce que** chaque point mémoire est constituée par un dispositif magnétique selon l'une des revendications 1 à 9.

11. Oscillateur radio fréquence, ***caractérisé* en ce qu'**il comprend un dispositif magnétique selon l'une des revendications 1 à 9.

12. Oscillateur radio fréquence selon la revendication 11, ***caractérisé* en ce que** l'électrode soluble du dispositif qui le constitué est réalisée en cobalt, la bicouche dudit dispositif faisant fonction de polariseur.

## Claims

1. Magnetic device integrating:
■ a magneto-resistive stack (3), said stack comprising at least two layers made out of a ferromagnetic material, separated from each other by a layer of non-magnetic material;
■ and means (2, 4, 7) for causing an electron current to flow perpendicular to the plane of said layers, with at least one integrated nano-contact intended to inject said current into the magneto-resistive stack (3),
***characterized* in that** the nano-contact is made in a bilayer (4) composed of a solid electrolyte (5) on which has been deposited a soluble electrode (6) composed of a metal and at least partially dissolved in said electrolyte.

2. Magnetic device as claimed in claim 1, ***characterized* in that** the electric current passing through the magnetic stack is spin polarized.

3. Magnetic device as claimed in one of claims 1 and 2, ***characterized* in that** the soluble electrode is at least partially dissolved in the solid electrolyte by UV treatment or heat treatment.

4. Magnetic device as claimed in one of claims 1 to 3, ***characterized* in that** the solid electrolyte (5) is constituted by a chalcogenide, and more particularly selected from the group comprising GeSe or GeS or GeTe or As₂Se.

5. Magnetic device as claimed in one of claims 1 to 4, ***characterized* in that** the soluble electrode (6) is selected from the group comprising silver, copper, cobalt, indium, zinc and platinum.

6. Magnetic device as claimed in one of claims 1 to 5, ***characterized* in that** the voltage applied to its terminals exceeds a threshold voltage (Vₜₕ), and **in that** the electron current passing through said magnetic stack is weaker than the saturation current and is controllable, as a function of the required size of the nano-contact or nano-contacts produced in the bilayer (4).

7. Magnetic device as claimed in one of claims 1 to 5, ***characterized* in that** the voltage applied at its terminals exceeds a threshold voltage (Vₜₕ), and **in that** the electron current passing through said magnetic stack is stronger than the saturation current, in such a way as to produce irreversible nano-contacts in the bilayer (4).

8. Magnetic device as claimed in one of claims 1 to 7, ***characterized* in that** it comprises between the stack of magnetic layers (3) and one of the contact electrodes (2, 7) a network of nano-contacts, each constituted by a bilayer (4), said network being mounted in parallel or in series.

9. Magnetic device as claimed in one of claims 1 to 7, ***characterized* in that** a bilayer (4) is positioned on either side of the magnetic stack (3), the solid electrolyte (5) of each of said bilayers being in contact with said stack, on the opposing faces thereof.

10. Magnetic random access memory constituted by a plurality of memory points,
***characterized* in that** each memory point is constituted by a magnetic device as claimed in one of claims 1 to 9.

11. Radio-frequency oscillator, ***characterized* in that** it comprises a magnetic device as claimed in one of claims 1 to 9.

12. Radio-frequency oscillator as claimed in claim 11, ***characterized* in that** the soluble electrode of the device constituting it is made out of cobalt, the bilayer of said device acting as polarizer.

## Patentansprüche

1. Magnetische Vorrichtung, in die integriert ist:
• ein magnetoresistiver Stapel (3), wobei dieser Stapel mindestens zwei aus einem ferromagnetischen Werkstoff hergestellte Schichten umfasst, die durch eine Schicht aus einem unmagnetischen Werkstoff voneinander getrennt sind;
• und Mittel (2, 4, 7), um einen Elektronenstrom senkrecht zu der Ebene dieser Schichten fließen zu lassen, in die mindestens ein Nanokontakt integriert ist, der dazu bestimmt ist, diesen Strom in den magnetoresistiven Stapel (3) einzuleiten,
**dadurch gekennzeichnet, dass** der Nanokontakt in einem Zweischichtelement (4) hergestellt ist, das aus einem festen Elektrolyt (5) besteht, auf den eine lösliche Elektrode (6) aufgebracht ist, die aus einem Metall besteht und mindestens partiell in dem Elektrolyt gelöst ist.

2. Magnetische Vorrichtung nach Anspruch 1, **dadurch gekennzeichnet, dass** der elektrische Strom, der den magnetischen Stapel durchquert, spinpolarisiert ist.

3. Magnetische Vorrichtung nach einem der Ansprüche 1 und 2, **dadurch gekennzeichnet, dass** die mindestens partielle Lösung der in dem festen Elektrolyt löslichen Elektrode durch UV-Behandlung oder Wärmebehandlung durchgeführt wird.

4. Magnetische Vorrichtung nach einem der Ansprüche 1 bis 3, **dadurch gekennzeichnet, dass** der feste Elektrolyt (5) aus einem Chalkogenid besteht, das insbesondere aus der Gruppe ausgewählt ist, die GeSe oder GeS oder GeTe oder As₂Se umfasst.

5. Magnetische Vorrichtung nach einem der Ansprüche 1 bis 4, **dadurch gekennzeichnet, dass** die lösliche Elektrode (6) aus der Gruppe ausgewählt ist, die Silber, Kupfer, Kobalt, Indium, Zink und Platin umfasst.

6. Magnetische Vorrichtung nach einem der Ansprüche 1 bis 5, **dadurch gekennzeichnet, dass** die an ihre Anschlüsse angelegte Spannung höher als eine Schwellenspannung (Vₜₕ) ist und dass der den magnetischen Stapel durchquerende Elektronenstrom niedriger als der Sättigungsstrom ist und steuerbar ist in Abhängigkeit von der gewünschten Abmessung des oder der in dem Zweischichtelement (4) hergestellten Nanokontakte.

7. Magnetische Vorrichtung nach einem der Ansprüche 1 bis 5, **dadurch gekennzeichnet, dass** die an ihre Anschlüsse angelegte Spannung höher als eine Schwellenspannung (Vₜₕ) ist und dass der den magnetischen Stapel durchquerende Elektronenstrom höher als der Sättigungsstrom ist, so dass in dem Zweischichtelement (4) irreversible Nanokontakte geschaffen werden.

8. Magnetische Vorrichtung nach einem der Ansprüche 1 bis 7, **dadurch gekennzeichnet, dass** sie zwischen dem Stapel von magnetischen Schichten (3) und einer der Kontaktelektroden (2, 7) ein Netzwerk von Nanokontakten umfasst, die jeweils aus einem Zweischichtelement (4) bestehen, wobei das Netzwerk parallel oder in Reihe eingebaut ist.

9. Magnetische Vorrichtung nach einem der Ansprüche 1 bis 7, **dadurch gekennzeichnet, dass** ein Zweischichtelement (4) zu beiden Seiten des magnetischen Stapels (3) angeordnet ist, wobei der feste Elektrolyt (5) jedes dieser Zweischichtelemente mit diesem Stapel auf Höhe dessen entgegengesetzter Seiten in Kontakt ist.

10. Magnetspeicher mit wahlfreiem Zugriff, bestehend aus einer Mehrzahl von Speicherstellen, **dadurch gekennzeichnet, dass** jede Speicherstelle aus einer magnetischen Vorrichtung nach einem der Ansprüche 1 bis 9 besteht.

11. Funkfrequenzoszillator, **dadurch gekennzeichnet, dass** er eine magnetische Vorrichtung nach einem der Ansprüche 1 bis 9 umfasst.

12. Funkfrequenzoszillator nach Anspruch 11, **dadurch gekennzeichnet, dass** die lösliche Elektrode der ihn bildenden Vorrichtung aus Kobalt hergestellt ist, wobei das Zweischichtelement dieser Vorrichtung als Polarisator dient.
